# EUROPEAN PATENT APPLICATION

(11) **EP 2 808 911 A2**
(43) Date of publication of application: **03.12.2014**
(21) Application number: 14170088.0
(22) Date of filing: 27.05.2014
(51) Int. Cl.: H01L 33/58, H01L 33/64, G02F 1/13357

(54) **Light source device adapted to a direct-type backlight module and display device therewith**

(30) Priority: 28.05.2013 TW 102118812
(71) Applicant: Pan, Yu Hsiang, Taipei City 116 (TW); Chan, Tzu-Yin, New Taipei City 241 (TW)
(72) Inventor: Pan, Yu Hsiang, Taipei City 116 (TW); Chan, Tzu-Yin, New Taipei City 241 (TW)
(74) Representative: Becker Kurig Straus

(57) **Abstract**

A light source device (38) includes a frame (40), at least one light emitting chip (42), a light transferring layer (54) and a lens layer (56). The at least one light emitting chip (42) is present within the frame (40) for emitting light. The light transferring layer (54) covers the at least one light emitting chip (42) and combines with the frame (40). The lens layer (56) is formed on the frame (40) and contacts and combines with the light transferring layer (54), such that the light emitted from the at least one light emitting chip (42) directly projects into the lens layer (56) after passing through the light transferring layer (54). The lens layer (56) has a light emitting surface (58) on the other face to the light transferring layer (54) for transferring the light emitted from the at least one light emitting chip (42) into a light shape after passing through the light transferring layer (54) and the lens layer (56).

## Description

### Field of the Invention

The present invention relates to a light source device and a display device according to claims 1 and 15.

### Background of the Invention

Generally speaking, a backlight module of a liquid crystal display (LCD) panel is used for providing the LCD panel with a sufficient and uniform light source, so that images are normally displayed on the LCD panel. Recently, since the backlight module equipped with a light emitting diode (LED) has advantages of lower power consumption, long life and lack of warming time, it has been gradually implemented in the LCD panel as a light source. Furthermore, the backlight module can be categorized into a direct-type lighting design and an edge-type lighting design according to where the LED is located. For example, the direct-type lighting design disposes the LED of the backlight module right below the LCD panel and is adapted to a display module with specifications of higher light intensity and larger size, such as a monitor, a LED TV and so on. With decreasing price of the LED TV, price of the backlight module equipped with the LED decreases. In practice, mechanisms of decreasing an amount of the LED of the backlight module are adopted for reducing cost of the backlight module with the LED.

However, the aforesaid mechanisms of decreasing the amount of the LED will reduce lighting density which the LEDs project on the LCD panel, so that the LCD panel cannot obtain the sufficiently uniform lighting. As far as the design is concerned, it can improve lighting uniformity of the LCD panel to enlarge light emitting angle of the LED for increasing projecting area of the LCD panel to which a single LED contributes. In addition, the aforesaid mechanisms of decreasing the amount of the LED will reduce lighting intensity which the LEDs project on the LCD panel, so that the LCD panel cannot obtain the sufficiently lighting intensity. Conventionally, it adopts to enhance driving current of the LED for increasing lighting flux of the single LED. However, the aforesaid design of enhancing driving current of the LED generates more heat, and thus results in raising temperature during functioning of the LED and curtailing the life of the LED component. Thus, designing a light source device with a large light-emitting angle and capability of enhancing heat dissipating efficiency becomes an issue in the industry.

### Summary of the Invention

This in mind, the present invention aims at providing a light source device and a display device with a large light-emitting angle and capability of enhancing heat dissipating efficiency.

This is achieved by a light source device and a display device according to claims 1 and 15. The dependent claims pertain to corresponding further developments and improvements.

As will be seen more clearly from the detailed description following below, the claimed light source device comprises a frame, at least one light emitting chip, a light transferring layer and a lens layer. The at least one light emitting chip is present within the frame, and the at least one light emitting chip is for emitting light. The light transferring layer covers the at least one light emitting chip and combines with the frame. The lens layer is formed on the frame. The lens layer contacts and combines with the light transferring layer, such that the light emitted from the at least one light emitting chip directly projects into the lens layer after passing through the light transferring layer. A light emitting surface is formed on the other face of the lens layer to the light transferring layer. The light emitting surface is for transferring the light emitted from the at least one light emitting chip into a light shape after the light passes through the light transferring layer and the lens layer.

### Brief Description of the Drawings

In the following, the invention is further illustrated by way of example, taking reference to the accompanying drawings. Thereof
FIG. 1 is a schematic diagram of a display device according to an embodiment of the present invention,
FIG. 2 is an exploded diagram of the display device according to the embodiment of the present invention,
FIG. 3 is a partly sectional diagram of the display device according to the embodiment of the present invention,
FIG. 4 and FIG. 5 are assembly diagrams of a light source device in different statuses according to the embodiment of the present invention,
FIG. 6 is an assembly diagram of the light source device in another status according to the embodiment of the present invention,
FIG. 7 is an assembly diagram of the light source device in another status according to the embodiment of the present invention,
FIG. 8 is a sectional diagram of a light source device according to another embodiment of the present invention,
FIG. 9 is a sectional diagram of a light source device according to another embodiment of the present invention, and
FIG. 10 is a sectional diagram of a light source device according to another embodiment of the present invention.

### Detailed Description

In the following detailed description of the embodiments, reference is made to the accompanying drawings which form a part hereof. They illustrate specific embodiments in which the invention may be practiced. In this regard, directional terminology, such as "top," "bottom," etc., is used with reference to the orientation of the Figure(s) being described. The components of the present invention can be positioned in a number of different orientations. As such, the directional terminology is used for purposes of illustration and is in no way limiting. On the other hand, the drawings are only schematic and the sizes of components may be exaggerated for clarity. It is to be understood that other embodiments may be utilized and structural changes may be made without departing from the scope of the present invention. Also, it is to be understood that the phraseology and terminology used herein is for the purpose of description and should not be regarded as limiting. The use of "including," "comprising," or "having" and variations thereof herein is meant to encompass the items listed thereafter and equivalents thereof as well as additional items. Unless limited otherwise, the terms "connected," and "installed" and variations thereof herein are used broadly and encompass direct and indirect connections and installations. Accordingly, the drawings and descriptions will be regarded as illustrative in nature and not as restrictive.

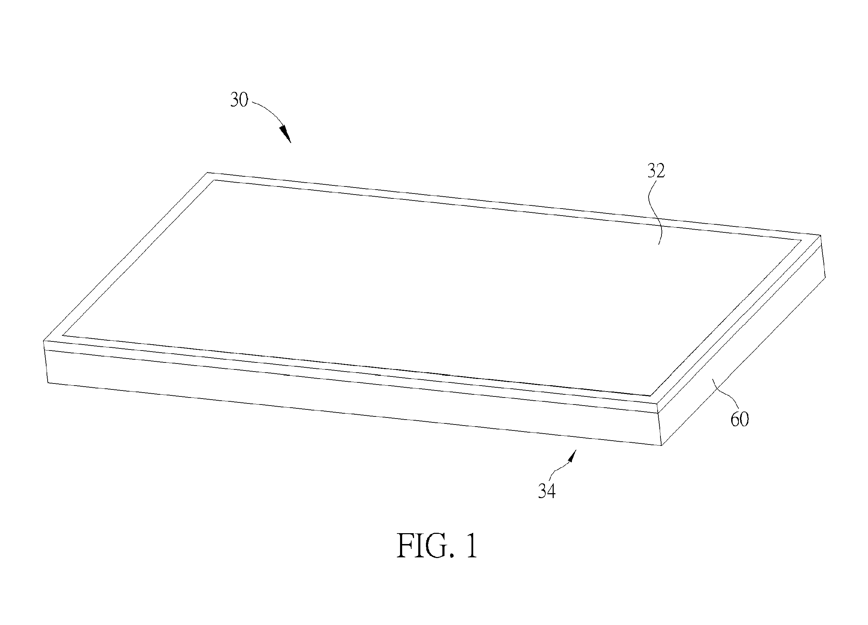

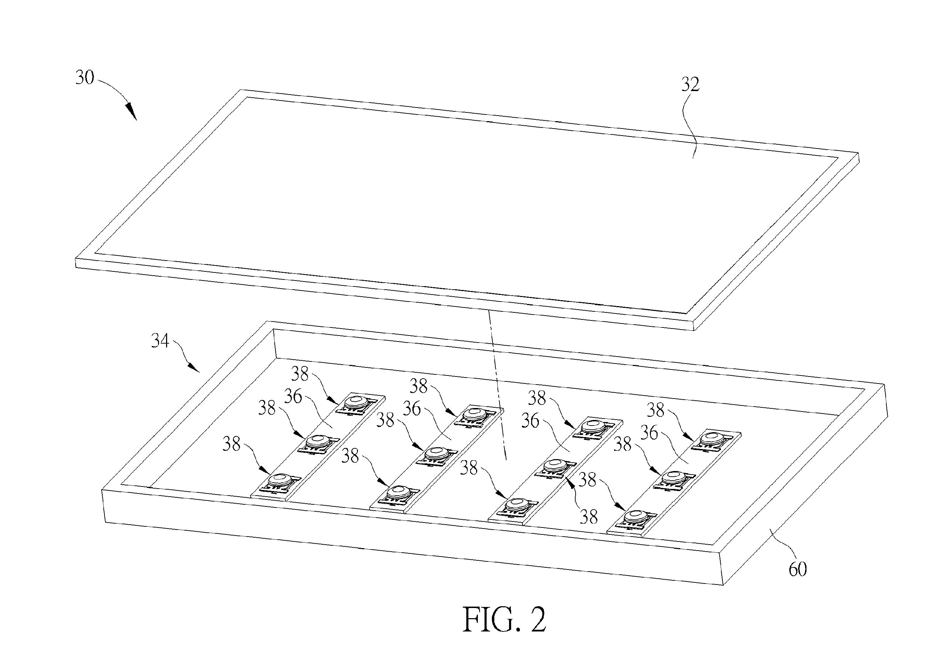

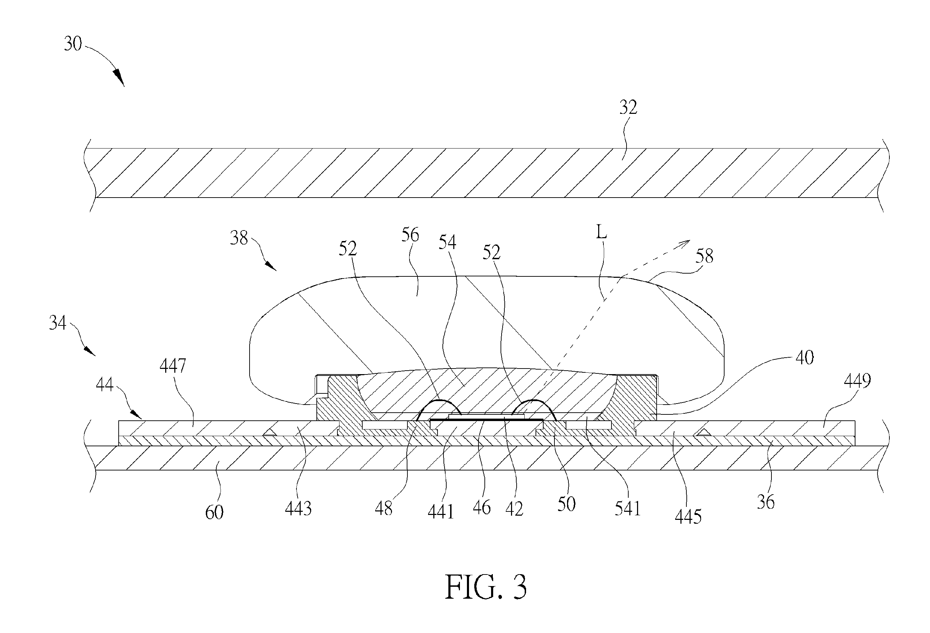

FIG. 1 is a schematic diagram of a display device 30 according to an embodiment of the present invention. FIG. 2 is an exploded diagram of the display device 30 according to the embodiment of the present invention. FIG. 3 is a partly sectional diagram of the display device 30 according to the embodiment of the present invention. As shown in FIG. 1 to FIG. 3, the display device 30 includes a display module 32 and a direct-type backlight module 34. The direct-type backlight module 34 is installed below the display module 32 and for providing the display module 32 with a light source, such that images are displayed normally on the display module 32. In this embodiment, the display device 30 is a light emitting diode television (LED TV), the display module 32 is a liquid crystal display (LCD) panel adapted to the LED TV, and the direct-type backlight module 34 is used for providing the LCD panel with the sufficient and uniform light source. Implementations of the display device 30 are not limited to those mentioned in this embodiment. For example, the display device 30 can be a monitor or a notebook/desktop computer and so on as well. As for which one of the aforesaid designs is adopted, it depends on practical demands.

Furthermore, the direct-type backlight module 34 includes at least one circuit board 36 and at least one light source device 38. The light source device 38 is electrically connected to the circuit board 36, such that the light source device 38 is driven by the circuit board 36 to emit the light. In this embodiment, the direct-type backlight module 34 includes four circuit boards 36, and each of the circuit boards 36 is equipped with three light source devices 38. Amounts of the circuit board 36 and the light source device 38 are not limited to those mentioned in this embodiment. For example, the direct-type backlight module 34 can include one circuit board 36, and the circuit board 36 can be equipped with one light source device 38 as well. In other words, mechanisms with more than one circuit board 36 and more than one light source device 38 are within the scope of the present invention. In practice, the circuit board 36 can be a printed circuit board (PCB). Furthermore, the direct-type backlight module 34 further includes a casing 60 installed below the display module 32. The casing 60 is used for supporting the circuit board 36 and the light source device 38 and further for protecting the circuit board 36, the light source device 38 and other internal components of the direct-type backlight module 34 from damages due to collision.

As shown in FIG. 3, the light source device 38 includes a frame 40 and at least one light emitting chip 42. The frame 40 is present between the circuit board 36 and the display module 32, and the light emitting chip 42 is present within the frame 40. In practice, the frame 40 is used for packaging the light emitting chip 42, such that the light emitting chip 42 is present within the frame 40 for being driven by the circuit board 36 to emit the light. Accordingly, the light source device 38 can provide the display module 32 with the light source, such that the images are normally displayed on the display module 32. In this embodiment, the light source device 38 includes one light emitting chip 42. An amount of the light emitting chip 42 is not limited to that mentioned in this embodiment. For example, the light source device 38 can include two or three light emitting chips 42, i.e. mechanisms with more than one light emitting chip 42 are within the scope of the present invention. As for which one of the aforesaid designs is adopted, it depends on practical demands.

In this embodiment, the light emitting chip 42 can be a light emitting diode chip. In addition, the light source device 38 further includes a heat conducting member 44 connected to the frame 40 and the circuit board 36. When the light emitting chip 42 emits the light, the heat conducting member 44 is used for conducting heat generated by the light emitting chip 42 to the circuit board 36, so as to dissipate the heat generated by the light emitting chip 42 as it is emitting the light. In this embodiment, the heat conducting member 44 is made of metal material. For example, the heat conducting member 44 can be, but not limited to, made of copper material, e.g. the heat conducting member 44 can be made of aluminum material as well. As for which one of the aforesaid designs is adopted, it depends on practical demands.

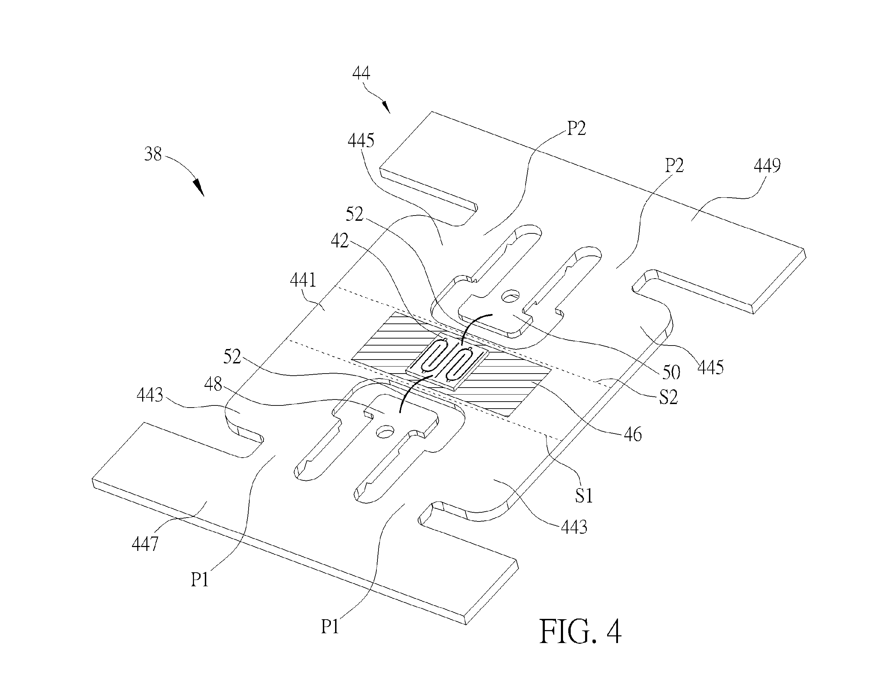

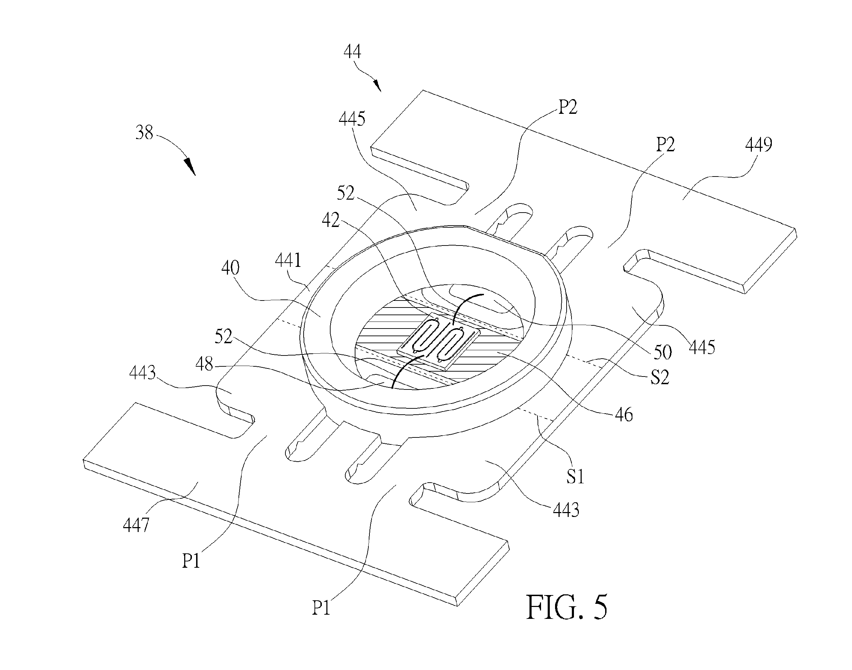

FIG. 4 and FIG. 5 are assembly diagrams of the light source device 38 in different statuses according to the embodiment of the present invention. As shown in FIG. 3 to FIG. 5, the heat conducting member 44 includes a main body 441, and the main body 441 has a first lateral side portion S1 and a second lateral side portion S2. When the light source device 38 is assembled, the light emitting chip 42 is disposed on the main body 441 first, as shown in FIG. 4, e.g. the light emitting chip 42 can be attached to the main body 441. Then, the frame 40 and the heat conducting member 44 are integrally formed, as shown in FIG. 5, so as to combine the frame 40 with the heat conducting member 44. In practice, the heat conducting member 44 and the frame 40 are integrally formed in an insert mold. In this embodiment, the frame 40 is an annular structure, and the light emitting chip 42 is located within the annular structure (i.e. the frame 40). In such a manner, the main body 441 can provide the light emitting chip 42 with a holding place, such that the light emitting chip 42 is packaged inside the annular structure (i.e. the frame 40) by the following process. In addition, when the light emitting chip 42 is driven by the circuit board 36 to emit the light, the heat generated by the light emitting chip 42 is conducted to the circuit board 36 via the main body 441, so as to dissipate the heat generated by the light emitting chip 42 as it is emitting the light.

Furthermore, the heat conducting member 44 further includes two first wing portions 443 and two second wing portions 445. The two first wing portions 443 respectively extend from the first lateral side portion S1 of the main body 441, and peripheries of the two first wing portions 443 exceed the annular structure (i.e. the frame 40). The two second wing portions 445 respectively extend from the second lateral side portion S2 of the main body 441, and peripheries of the two second wing portions 445 exceed the annular structure (i.e. the frame 40). When the light emitting chip 42 is driven by the circuit board 36 to emit the light, the heat generated by the light emitting chip 42 can be conducted to the circuit board 36 not only via the main body 441, but also via the two first wing portions 443 and the two second wing portions 445. In other words, the two first wing portions 443 and the two second wing portions 445 are used for conducting the heat conducted from the main body 441 and generated by the light emitting chip 42 to the circuit board 36, i.e. the first wing portions 443 and the second wing portions 445 of the present invention can be utilized for increasing conducting area of the heat conducting member 44, so as to rapidly conduct the heat generated by the light emitting chip 42 to the circuit board 36 for enhancing heat dissipating efficiency of the heat conducting member 44.

As shown in FIG. 3 to FIG. 5, the light source device 38 further includes a heat conducting film layer 46 formed between the light emitting chip 42 and the main body 441 of the heat conducting member 44. In this embodiment, the heat conducting film layer 46 is a diamond-like carbon film layer. In practice, the diamond-like carbon film layer (i.e. the heat conducting film layer 46) is formed on the main body 441 in a sputtering manner. Furthermore, the diamond-like carbon film has property of laterally-oriented heat conduction. When the light emitting chip 42 emits the light, the heat conducting film layer 46 (i.e. the diamond-like carbon film layer) can be utilized for conducting the heat to a periphery of the main body 441, the two first wing portions 443 and the two second wing portions 445, laterally. Accordingly, the conducting areas of the main body 441, the two first wing portions 443 and the two second wing portions 445 of the heat conducting member 44 of the present invention can be fully utilized for rapidly conducting the heat generated by the light emitting chip 42 to the circuit board 36, so as to enhance the heat dissipating efficiency of the light source device 38.

In summary, the first wing portions 443 and the second wing portions 445 of the present invention are utilized for increasing the heat conducting areas of the heat conducting member 44, so as to rapidly conduct the heat generated by the light emitting chip 42 to the circuit board 36 for enhancing the heat dissipating efficiency of the light source device 38. Furthermore, since the heat conducting film layer 46 of the present invention has the property of laterally-oriented heat conduction, the heat conducting film layer 46 conducts the heat generated by the light emitting chip 42 laterally to the periphery of the main body 441, the two first wing portions 443 and the two second wing portions 445. Accordingly, the conducting areas of the main body 441, the first wing portions 443 and the second wing portions 445 are fully utilized for further enhancing the heat dissipating efficiency of the light source device 38. In such a manner, the present invention can utilize the first wing portions 443, the second wing portions 445 and the heat conducting film layer 46 for enhancing the heat dissipating efficiency of the light source device 38, so as to prevent curtailment of the life of the light emitting chip 42 under high working temperature.

It should be noticed that the heat conducting member 44 can include a first feeding strip structure 447 and a second feeding strip structure 449. The first feeding strip structure 447 is connected to end portions P1 of the two first wing portions 443, and the second feeding strip structure 449 is connected to end portions P2 of the two second wing portions 445. When the heat conducting member 44 is manufactured, the first feeding strip structure 447 and the second feeding strip structure 449 can be utilized for supporting the two first wing portions 443 and the two second wing portions 445 during the manufacture process, so as to facilitate to proceed manufacture process of the heat conducting member 44.

As shown in FIG. 3 to FIG. 5, the light source device 38 further includes a first electrode 48, a second electrode 50 and two conducting wires 52. The first electrode 48 is coupled to the circuit board 36 and located in a position between the main body 441 and the two first wing portions 443, and the second electrode 50 is coupled to the circuit board 36 and located in a position between the main body 441 and the two second wing portions 445. In addition, the two conducting wires 52 are used for electrically connecting the light emitting chip 42 to the first electrode 48 and the second electrode 50 respectively, such that the light emitting chip 42 is coupled to the circuit board 36. Accordingly, the circuit board 36 can drive the light emitting chip 42 to emit the light via the first electrode 48, the second electrode 50 and the two conducting wires 52, such that the light source device 38 provides the display module 32 with the light source and allows the images to be normally displayed on the display module 32.

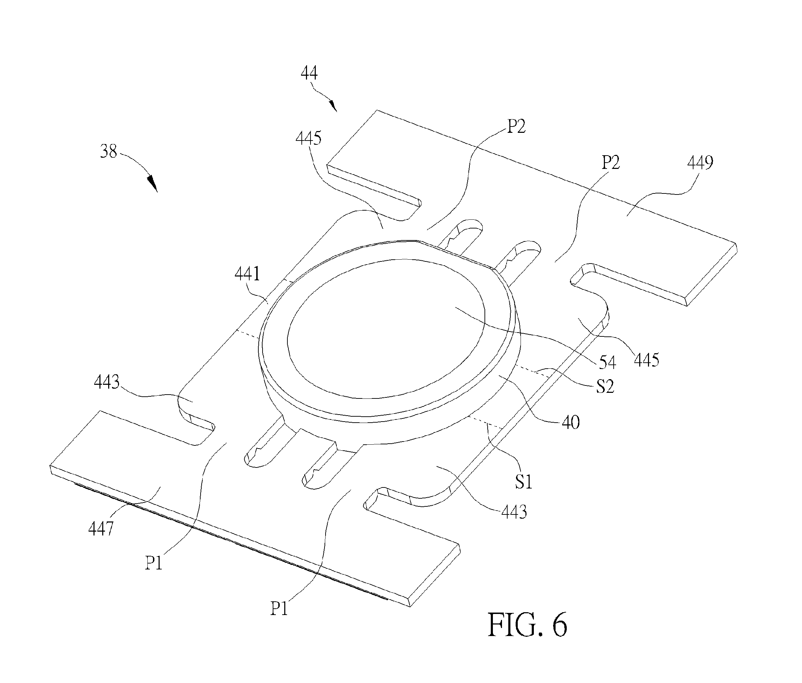

FIG. 6 is an assembly diagram of the light source device 38 in another status according to the embodiment of the present invention. As shown in FIG. 3 and FIG. 6, the light source device 38 further includes a light transferring layer 54 covering the light emitting chip 42 and combining with the frame 40. In practice, when the light emitting chip 42 and the frame 40 are combined with the heat conducting member 44, the frame 40 (i.e. a central portion of the annular structure) is filled with the light transferring layer 54. Additionally, the light transferring layer 54 can include a color conversion material layer 541, as shown in FIG. 3, for transferring the light emitted from the light emitting chip 42 (e.g. blue light) into white light for meeting user's demands. In other words, combination of the color conversion material layer 541 of the light transferring layer 54 and the light emitting chip 42 of the light source device 38 can be utilized for transferring the light emitted from the light emitting chip 42 into the general white light, so as to enhance flexibility of the light source device 38 and the light emitting chip 42. In practice, the color conversion material layer 541 is made of fluorescent powders.

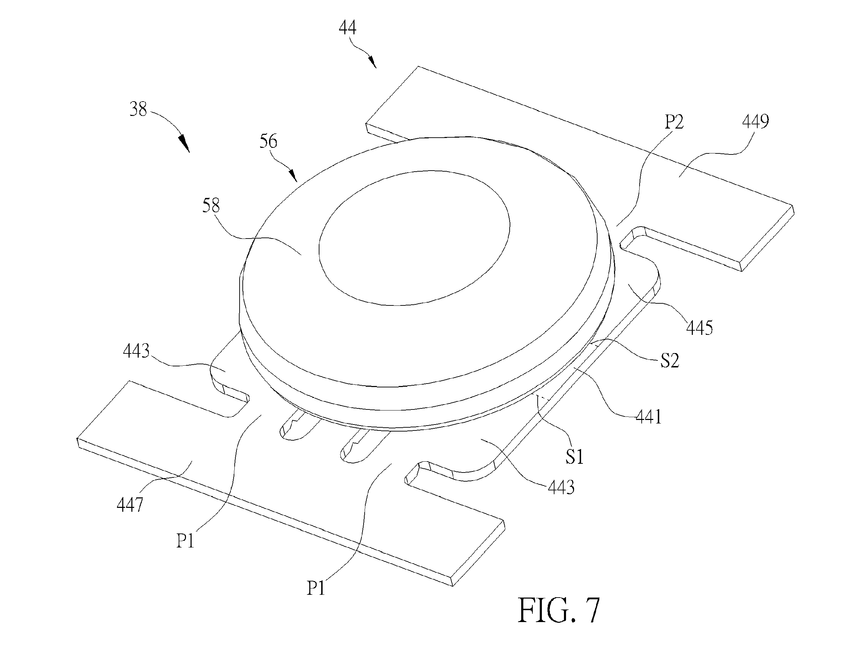

FIG. 7 is an assembly diagram of the light source device 38 in another status according to the embodiment of the present invention. As shown in FIG. 3 and FIG. 7, the light source device 38 further includes a lens layer 56 formed on the frame 40, and the lens layer 56 contacts and combines with the light transferring layer 54, i.e in the present invention, the lens layer 56 and the light transferring layer 54 of the light source device 38 contact each other without an air gap being formed therebetween. In this embodiment, the lens layer 56 and the light transferring layer 54 are integrally formed in an insert mold, but the present invention is not limited thereto. For example, the lens layer 56 and the light transferring layer 54 are integrally formed in an attaching mold as well. It should be noticed that an interface where the light transferring layer 54 attaches the lens layer 56 is not that illustrated in figures in this embodiment. For example, the interface where the light transferring layer 54 attaches the lens layer 56 can be a flat surface, a curved surface, e.g. a convex surface, a concave surface and so on. As for which one of the above-mentioned designs is adopted, it depends on practical demands. In practice, the light transferring layer 54 and the lens layer 56 can be made of the same material, such as silica gel material. As shown in FIG. 3, a light emitting surface 58 is formed on the other face of the lens layer 56 to the light transferring layer 54. As mentioned above, the light transferring layer 54 and the lens layer 56 are made of the same material. Thus, when a light L emitted from the light emitting chip 42 passes through the light transferring layer 54 and enters the lens layer 56, the light L directly projects from the light transferring layer 54 into the lens layer 56 without refraction since the light L passes through the light transferring layer 54 and the lens layer 56 with the same material.

Furthermore, since the lens layer 56 and the light transferring layer 54 contact each other without the air gap being formed therebetween, the light L directly projects from the light transferring layer 54 into the lens layer 56 without passing through the air gap. In other words, since there is no refraction occurring at the interface between the light transferring layer 54 and the lens layer 56, i.e. the light L does not refract from the light transferring layer 54 into the air gap and then from the air gap into the lens layer 56, the present invention reduces loss of power of the light L. In other words, the structural design of the present invention that the lens layer 56 and the light transferring layer 54 are integrally formed facilitates to keep flux of the light L, so as to keep light emitting efficiency of the light source device 38. Experimentally, the light emitting efficiency of the light source device 38 adopting the aforesaid structural design achieves 64.9%.

When the light L projects to the light emitting surface 58 of the lens layer 56 via the light transferring layer 54 and the lens layer 56, an arc of the light emitting surface 58 transforms the light L as passing thereto into a light shape, so as to provide the display module 32 with the light source. Furthermore, during the process that the light L emitted from the light emitting chip 42 to the lens layer 56, the light L is refracted once at the light emitting surface 58 of the lens layer 56 to form the light shape, instead of being optically concentrated at the light transferring layer 54 first and then optically processed at the light emitting surface 58 of the lens layer 56. In other words, the structural design of the light source device 38 of the present invention that the lens layer 56 and the light transferring layer 54 are integrally formed allows the light L emitted from the light emitting chip 42 to diverge into the light transferring layer 54 and the lens layer 56 without optical concentration. As a result, the aforesaid design facilitates enlargement of the light emitting angle of the light source device 38. In such a manner, the present invention can enlarge a projection area that the single light source device 38 projects to the display module 32, so as to improve illuminating uniformity of the display module 32. The light emitting angle of the light source device 38 of the present invention can achieve 150 degrees by optical simulation..

In addition, since the light transferring layer 54 of the present invention does not need to concentrate the light L emitted from the light emitting chip 42, in structural design aspect, the light transferring layer 54 of the present invention does not need to form a lens structure, resulting in constraint of volume, at the interface between the light transferring layer 54 and the lens layer 56. In such a manner, the present invention can enlarge the light transferring layer 54 for enlarging the frame 40 adapted to package the light emitting chip 42 and the light transferring layer 54. As a result, the present invention enables to enlarge the frame 40 for facilitating heat conduction, so as to enhance the heat dissipating efficiency of the light source device 38.

In this embodiment, the frame 40 of the present invention is made of silica gel material. In practice, the light emitting chip 42 of the light source device 38 can be fixed on the circuit board 36 in a surface mount technology (SMT) manner. A process temperature of the surface mount technology is around 280°C, while the frame 40, the light transferring layer 54 and the lens layer 56 of the present invention are all made in silica gel materials whose melting point is up to 380°C. In other words, the frame 40, the light transferring layer 54 and the lens layer 56 of the present invention can endure the process temperature of the SMT process. As a result, the present invention is capable of packaging the light emitting chip 42, the light transferring layer 54 and the lens layer 56 inside frame 40 first, and then fix the frame 40 with the light emitting chip 42, the light transferring layer 54 and the lens layer 56 on the circuit board 36 together by the SMT process, so as to decrease assembly cost and further to enhance the advantages of product in the market.

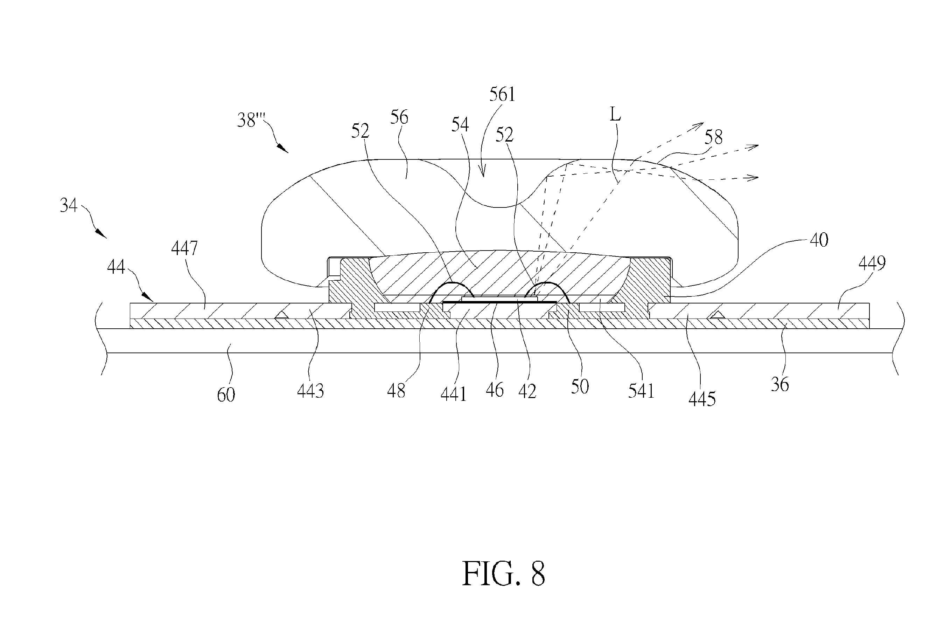

FIG. 8 is a sectional diagram of a light source device 38"' according to another embodiment of the present invention. The main difference between the light source device 38"' and the aforesaid light source device 38 is that a recess portion 561 is formed on the lens layer 56. As shown in FIG. 8, the recess portion 561 is located in a geometrically symmetric center of the light emitting surface 58, i.e. the recess portion 561 is located in a position right above the light emitting chip 42. Accordingly, the recess portion 561 can be used for reflecting the light projected to the recess portion 561 aside, so as to enlarge the light emitting angle of the light source device 38"'. Components with denoted in this embodiment identical to those in the aforesaid embodiment have identical structures and functions, and further description is omitted herein for simplicity.

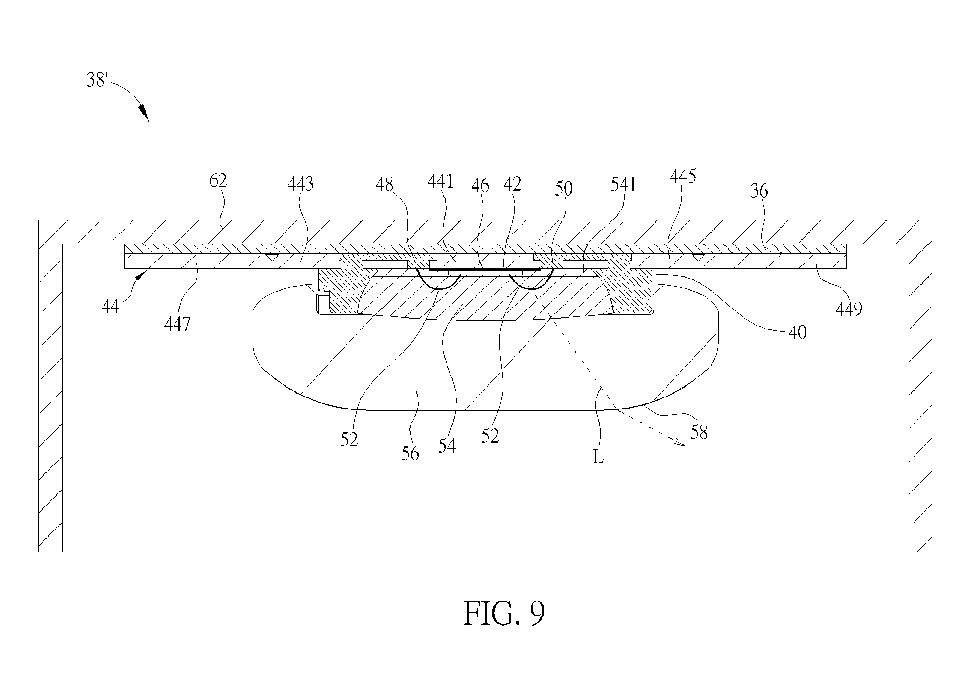

FIG. 9 is a sectional diagram of a light source device 38' according to another embodiment of the present invention. The main difference between the light source device 38' and the aforesaid light source device 38 is that the light source device 38' includes a lamp mask 62 and the light emitting chip 42 is present inside the lamp mask 62. In this embodiment, the light source device 38' is an illuminating device, such as an illuminating lamp. As mentioned above, when the light emitting chip 42 is driven to emit the light by the circuit board 36, the lamp mask 62 is used for projecting to an object the light emitted from the light emitting chip 42, so as to illuminate the object. In this embodiment, the object can be a cropper, i.e. the light source device 38' (i.e. the illuminating device) is used for providing the cropper with the light source for growth. The implementation of the light source device 38' (i.e. the illuminating device) of the present invention is not limited to those mentioned in this embodiment. For example, the light source device 38' (i.e. the illuminating device) can be used for general illuminating purpose as well, such as a traffic light, a lamp and so on, and it depends on practical demands. Components with denoted in this embodiment identical to those in the aforesaid embodiment have identical structures and functions, and further description is omitted herein for simplicity.

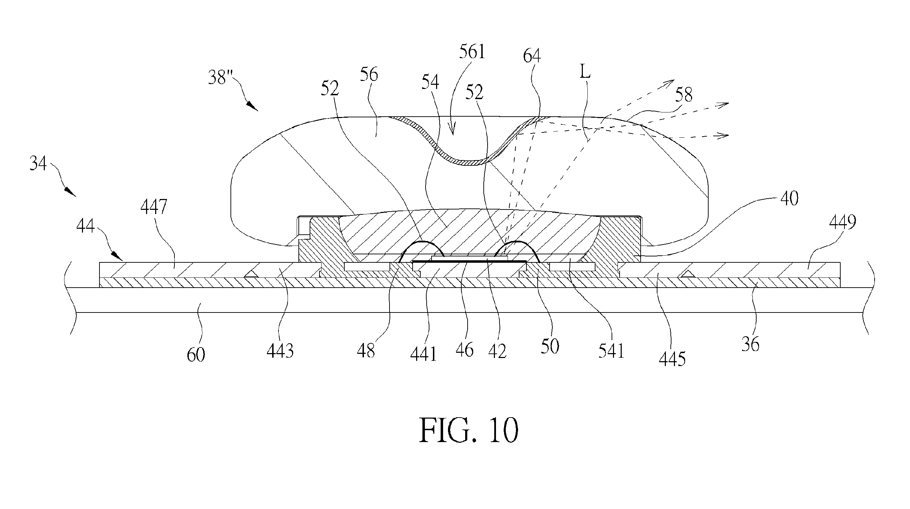

FIG. 10 is a sectional diagram of a light source device 38" according to another embodiment of the present invention. The main difference between the light source device 38" and the aforesaid light source device 38'" is that the light source device 38" further includes a reflective layer 64 coated in the recess portion 561. Accordingly, the reflective layer 64 can be used for reflecting the light projected to the recess portion 561 aside cooperatively with the recess portion 561, so as to enlarge the light emitting angle of the light source device 38". Components with denoted in this embodiment identical to those in the aforesaid embodiment have identical structures and functions, and further description is omitted herein for simplicity.

Compared to the prior art, the first wing portions and the second wing portions of the present invention are utilized for increasing the heat conducting areas of the heat conducting member, so as to rapidly conduct the heat generated by the light emitting chip to the circuit board for enhancing the heat dissipating efficiency of the light source device. Furthermore, since the heat conducting film layer of the present invention has the property of laterally-oriented heat conduction, the heat conducting film layer conducts the heat generated by the light emitting chip laterally to the periphery of the main body, the two first wing portions and the two second wing portions. Accordingly, the conducting areas of the main body, the two first wing portions and the two second wing portions are fully utilized for further enhancing the heat dissipating efficiency of the light source device. In such a manner, the present invention can utilize the first wing portions, the second wing portions and the heat conducting film layer for enhancing the heat dissipating efficiency of the light source device, so as to prevent curtailment of the life of the light emitting chip under high working temperature.

Furthermore, the structural design of the present invention that the lens layer and the light transferring layer are integrally formed allows the light emitted from the light emitting chip of the light source device directly projects into the lens layer from the light transferring layer without passing through the air gap, so as to reduce the loss of power of the light and further to keep flux of the light L. Additionally, the structural design of the light source device of the present invention that the lens layer and the light transferring layer are integrally formed allows the light emitted from the light emitting chip to directly diverge into the light transferring layer and the lens layer without optical concentration. As a result, the aforesaid design facilitates enlargement of the light emitting angle of the light source device. In such a manner, the present invention can enlarge a projection area that the single light source device projects to the display module, so as to improve illuminating uniformity of the display module.

In addition, since the light transferring layer of the present invention does not need to concentrate the light emitted from the light emitting chip, in structural design aspect, the light transferring layer 54 of the present invention does not need to form a lens structure, resulting in constraint of volume, at the interface between the light transferring layer and the lens layer. In such a manner, the present invention can enlarge the light transferring layer for enlarging the frame adapted to package the light emitting chip and the light transferring layer. As a result, the present invention enables to enlarge the frame for facilitating heat conduction, so as to enhance the heat dissipating efficiency of the light source device.

Furthermore, the frame of the present invention is made of silica gel material. In practice, the light emitting chip of the light source device can be fixed on the circuit board in a surface mount technology manner. A process temperature of the surface mount technology is around 280°C, while the frame, the light transferring layer and the lens layer of the present invention are all made in silica gel materials whose melting point is up to 380°C. In other words, the frame, the light transferring layer and the lens layer of the present invention can endure the process temperature of the SMT process. As a result, the present invention is capable of packaging the light emitting chip, the light transferring layer and the lens layer inside frame first, and then fix the frame with the light emitting chip the light transferring layer and the lens layer on the circuit board together by the SMT process, so as to decrease assembly cost and further to enhance the advantages of product in the market.

Those skilled in the art will readily observe that numerous modifications and alterations of the device and method may be made while retaining the teachings of the invention. Accordingly, the above disclosure should be construed as limited only by the metes and bounds of the appended claims.

## Claims

1. A light source device (38, 38', 38"), comprising:
a frame (40);
at least one light emitting chip (42) present within the frame (40);
a light transferring layer (54) covering the at least one light emitting chip (42) and combining with the frame (40);
a lens layer (56) formed on the frame (40), the lens layer (56) contacting and combining with the light transferring layer (54), such that the light emitted from the at least one light emitting chip (42) directly projects into the lens layer (56) after passing through the light transferring layer (54); and
a light emitting surface (58) being formed on the other face of the lens layer (56) to the light transferring layer (54), the light emitting surface (58) being for transferring the light emitted from the at least one light emitting chip (42) into a light shape after the light passes through the light transferring layer (54) and the lens layer (56).

2. The light source device (38, 38') of claim 1, **characterized in that** the light transferring layer (54) and the lens layer (56) are made of the same material.

3. The light source device (38, 38') of claim 2, **characterized in that** the light transferring layer (54) and the lens layer (56) are made of silica gel material.

4. The light source device (38, 38') of any of claims 1-3, **characterized in that** the light transferring layer (54) comprises a color conversion material layer (541) for transferring the light emitted from the at least one light emitting chip (42) into white light.

5. The light source device (38, 38') of any of claims 1-4, **characterized in that** the frame (40) is made of silica gel material.

6. The light source device (38, 38') of any of claims 1-5, **characterized in that** the lens layer (56) and the light transferring layer (54) are integrally formed in an insert mold or when being attached.

7. The light source device (38) of any of claims 1-6, **characterized by** further comprising:
a circuit board (36) coupled to the at least one light emitting chip (42), the circuit board (36) being for driving the at least one light emitting chip (42) to emit the light; and
a heat conducting member (44) connected to the frame (40) and the circuit board (36), the heat conducting member (44) being for conducting heat generated by the at least one light emitting chip (42) to the circuit board (36).

8. The light source device (38) of claim 7, **characterized in that** the frame (40) is an annular structure, and the heat conducting member (44) comprises:
a main body (441) having a first lateral side portion (S1) and a second lateral side portion (S2), the at least one light emitting chip (42) being present on the main body (441) and located within the annular structure;
two first wing portions (443) extending from the first lateral side portion (S1) of the main body (441), the two first wing portions (443) being for conducting the heat conducted from the main body (441) and generated by the at least one light emitting chip (42) to the circuit board (36); and
two second wing portions (445) extending from the second lateral side portion (S2) of the main body (441), the two second wing portions (445) being for conducting the heat conducted from the main body (441) and generated by the at least one light emitting chip (42) to the circuit board (36).

9. The light source device (38) of claim 8, **characterized by** further comprising:
a heat conducting film layer (46) formed between the at least one light emitting chip (42) and the main body (441), the heat conducting film layer (46) being for conducting the heat generated by the at least one light emitting chip (42) to the main body (441), the two first wing portions (443) and the two second wing portions (445).

10. The light source device (38) of claim 9, **characterized in that** the heat conducting film layer (46) is a diamond-like carbon film layer formed on the main body (441) in a sputtering manner.

11. The light source device (38) of claim 8, **characterized by** further comprising:
a first electrode (48) coupled to the circuit board (36) and located in a position between the main body (441) and the two first wing portions (443);
a second electrode (50) coupled to the circuit board (36) and located in a position between the main body (441) and the two second wing portions (445); and
two conducting wires (52) for electrically connecting the at least one light emitting chip (42) to the first electrode (48) and the second electrode (50) respectively, such that the at least one light emitting chip (42) is coupled to the circuit board (36).

12. The light source device (38) of any of claims 7-11, **characterized in that** the heat conducting member (44) is made of metal material, and the heat conducting member (44) and the frame (40) are integrally formed in an insert mold.

13. The light source device (38') of any of claims 1-6, **characterized by** further comprising:
a circuit board (36) coupled to the at least one light emitting chip (42), the circuit board (36) being for driving the at least one light emitting chip (42) to emit the light; and
a lamp mask (62), the at least one light emitting chip (42) being present inside the lamp mask (62), the lamp mask (62) being for projecting to an object the light emitted from the at least one light emitting chip (42).

14. The light source device (38") of claim 1, **characterized in that** a recess portion (561) is formed on the lens layer (56), and the light source device (38") further comprises:
a reflective layer (64) coated in the recess portion (561), the reflective layer (64) being for reflecting the light projected to the recess portion (561) aside.

15. The light source device (38"') of claim 1, **characterized in that** a recess portion (561) is formed on the lens layer (56) for reflecting the light projected to the recess portion (561) aside.

16. A display device (30), comprising:
a display module (32); and
a direct-type backlight module (34) installed below the display module (32) and for providing the display module (32) with a light source, the direct-type backlight module (34) comprising:
the light source device (38, 38', 38") of any of claims 1-14.
